# EUROPEAN PATENT SPECIFICATION

(11) **EP 1 525 085 B1**
(45) Date of publication and mention of the grant of the patent: **09.11.2005**
(21) Application number: 03771299.9
(22) Date of filing: 24.07.2003
(51) Int. Cl.: B29C 67/00

(54) **METHOD AND DEVICE FOR FORMING A BODY HAVING A THREE-DIMENSIONAL STRUCTURE**
VERFAHREN UND VORRICHTUNG ZUR HERSTELLUNG EINES KÖRPERS MIT EINER DREIDIMENSIONALEN STRUKTUR
PROCEDE ET DISPOSITIF DE FORMATION D'UN CORPS DE STRUCTURE TRIDIMENSIONNELLE

(30) Priority: 31.07.2002 JP 2002223471
(43) Date of publication of application: 27.04.2005
(73) Proprietor: Kawasaki, Akira, Sendai-shi Miyagi 981-0513 (JP); J-TEC, INC, Chiyoda-ku Tokyo 101-0043 (JP)
(72) Inventor: Kawasaki, Akira, Miyagi 981-0513 (JP)
(74) Representative: Albrecht, Thomas
(86) International application number: PCT/JP2003/009371
(87) International publication number: WO 2004/011177

(56) References cited:
- WO-A-01/14093
- US-A- 5 653 381
- US-A1- 2001 011 828

## Description

### Field of the Invention

The present invention relates to a method for forming a body having a three-dimensional structure and a device for forming the body in accordance with the method. The present invention particularly relates to a method and a device for forming a body having a three-dimensional structure in which spherical fine particles are arranged in three dimensions and the neighboring particles are bonded to each other.

### Background of the Invention

A method for forming a body by sintering spherical fine particles appeared in Material Integration (vol.14, No.8 (2001), pp.51-54) in which spherical fine particles of Bi-Sb alloy having a diameter of about 500 µm are aligned closely and then applied with electricity through themselves to sinter them together by Joule heat. A method for forming a body having a three-dimensional structure also appeared on page 54 of the above document in which particles are arranged in three-dimensions closely and then applied with electricity through themselves to sinter them.

In the body having a three-dimensional structure formed in accordance with the above method, the particles are located with a large variation in location due to variations of their sphericity and shift in the location thereof occurring in the sintering process.

When the size distribution of the particles is about 3% of the average diameter thereof, for example, the sphericity thereof varies by about 2%. If the particles having large variations of sphericity are sintered in accordance with the above conventional method, the center of each particle in the three-dimensional body inevitably deviates from the target position where the particle should be positioned.

Even when the sphericity of each particle is very high, the particles deviate due to shrinkage and local fusion while they are sintered.

### Summary of the Invention

The present invention provides a method for forming a body having a three-dimensional structure in which spherical fine particles are arranged in three dimensions and the neighboring particles are bonded to each other. The body is formed by repeatedly conducting a process consisting of steps of bringing a particle into contact with at least one other particle; forming fused areas at the contact areas of the particles; adjusting the location of the particle before the fused areas become hard; and hardening the fused areas to bond the particles.

A device for forming a body having a three-dimensional structure of the present invention is designed to form a body having a three-dimensional structure in which spherical fine particles are arranged in three dimensions and the neighboring particles are bonded to each other. The device has a holder for holding a particle on its tip, a mover for moving the holder, an energy beam irradiator to irradiate an energy beam to the outer surface of the particle held by the holder, and a controller for controlling a process consisting of steps of moving the holder holding a particle by the mover to bring the particle in contact with at least one other particle; fusing the contact areas of the particles; adjusting the location of the particle held by the holder before the fused contact areas become hard; and hardening the fused areas to bond the particles to each other.

### Brief Description of the Drawings

Fig.1 is a schematic view illustrating an embodiment of a method of arranging particles in a method for forming a body having a three-dimensional structure according to the present invention;
Fig.2 is a schematic view illustrating a manipulator of a device of an embodiment of the invention; and
Figs.3a, 3b and 3c are plan views illustrating arrangement of spherical fine particles, respectively.

### Description of the Preferred Embodiments

For forming a body having a three-dimensional structure in accordance with an embodiment the present invention, a spherical fine particle is made contact with other particles, and contact areas where they are in contact with each other are fused. Then, the particle is adjusted its position, before the fused areas become hard, so that the three-dimensional body consists of bonded particles, each of which is precisely positioned at a target position where it should be positioned.

The contact areas of the particles are preferably fused in such a manner that the particles are heated at the contact areas locally, namely only at the contact areas. At least one energy beam irradiator such as a laser beam irradiator is preferably used as a heater for heating the contact areas locally.

In one embodiment of the present invention, the diameter the particle is measured before it is brought in contact with other particles. The particle is moved on the basis of the measurement so that they are brought in contact with each other.

On the definition that the average distance between the centers of the particles constituting the three-dimensional body is expressed by "d", the average diameter of the particle before bonded is expressed by "d + Δd", and the standard deviation of the size distribution of the particles before they are bonded is expressed by " σ ", then Δd is preferably 2.5 to 4 times as large as the standard deviation σ.

The spherical fine particles preferably have an diameter of 1000 µm or smaller, particularly of 0.1 to 1000 µm, more particularly of 1 to 500 µm.

The spherical fine particles which are fused when they are heated may be of metals including alloys, ceramics and thermoplastic synthetic resins.

When a body having a three-dimensional structure is formed, the first particle is carried to its target position by a mover. The first particle is preferably fixed on a base by some kind of fixer such as adhesion, fusion and suctorial retention.

The second particles is held by a holder and brought in contact with the first particle. Then, an energy beam such as a laser beam is irradiated to the contact area of the particles so as to fuse the area. The location of the second particle is adjusted to its target position, preferably in such a manner that the second particle is moved toward the previously positioned first particle, before the fused area becomes hard. After that, the fused area is hardened.

Each of the third and later particles is brought into contact with the previously positioned particle, fused at its contact area, moved to its target position, and then the fused contact area is hardened, in accordance with the same manner as the second particle, respectively.

A layer may be preferably formed by arranging the particles in two dimensions in such a manner that the particles are aligned in one dimension firstly to form the first line, and then the second and later lines of particles are formed close to the previously formed line. Each of the particles of the second and later lines is bonded to the particles of the previously aligned line. The second and later layers consisting of the particles are preferably formed in the same manner as the first layer, respectively.

In one embodiment, after the first layer of particles constituting the bottom of the three-dimensional body is formed, the second layer of particles is formed on the first layer, and each of the third and later layers is formed on the previously formed layer.

The particles aligned in the second and later layers are bonded to the plural particles of the layer which is previously formed.

The body thus formed has a three-dimensional structure in which the particles are arranged in three dimensions regularly just as a crystal model. Therefore, the target position in a three-dimensional coordinate space to which each particle has to be positioned may be referred to as the "lattice point", and the distance between the lattice points may be referred to as the "lattice spacing", by using the nomenclature for crystallography.

The spherical fine particles before bonding may have an average diameter larger than the lattice space "d" by a determined certain value "Δd". When the average diameter of the particles before bonding is expressed by "d + Δd", and the standard deviation of the size distribution of the particles before bonding is expressed by " σ ", " Δd" is preferably 2.5 to 4 times, specifically about 3 times, as large as "σ".

Hereinafter, a method of arranging two particles A and B such that the distance between the centers of the particles A and B becomes d.

When the two particles A, B are brought in contact with each other, the distance between the center of each particle is larger than the lattice space "d" by at least Δd. The deviation of the distance between the particles A, B from the "d" value is detected accurately by measuring precisely the diameters of the particles by a particle diameter detecting device. Then, a locally heating energy beam, preferably a laser beam, is irradiated to the contact area of the particles A and B from a beam source having a power enough to fuse the material of the particles, so as to fuse the contact area of the particles locally. One of the particles A and B is moved to adjust the location thereof precisely such that the distance between the centers thereof becomes "d", before the fused area becomes hard, for example, due to solidification.

In any case, each particle can be positioned precisely in such a manner that all the contact areas of the particle to neighboring particles are fused simultaneously, and the particle is moved to adjust its position as like as above.

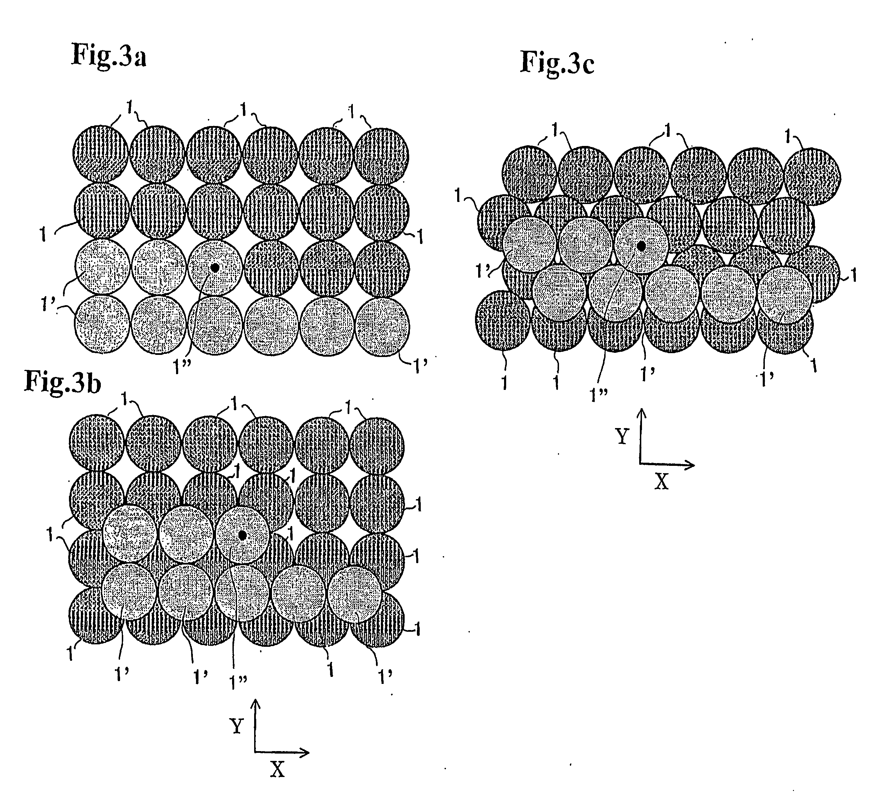

When a body having a primitive cubic lattice structure as shown in Fig.3a, particles 1 are located on two dimensional tetragonal lattice points, respectively, to form the first layer; secondly particles 1' are arranged right on the top the particles 1 of the first layer respectively to form the second layer. The third and later layers (not shown) are arranged in the same manner, so that a three-dimensional cubic lattice structure is constructed. A particle 1" which has just been positioned is in contact with three previously positioned particles, one of which is the particle 1 constituting the first layer and the two others are the particles 1' constituting the second layer. Therefore, three laser beams are required to bond the particle 1" to three particles 1, 1', 1', respectively.

In case of a body-centered cubic lattice structure (BCC) as shown in Fig.3b, the particles 1 are positioned on two-dimensional tetragonal lattice points respectively to form the first layer. In the second layer, the particles 1' are positioned on the center of the adjoining four particles 1 of the first layer to form a tetragonal lattice which slips a half period relative to the first layer. The third and later odd layers are formed in the same pattern as the first layer, and the fourth and latter even layers are formed in the same patterns as the second layer alternately, so that a three-dimensional body-centered cubic lattice structure (BCC) is constructed. A particle 1" which has just been positioned is in contact with six previously positioned particles, four of which are the particles 1 constituting the first layer and the others are the two particles 1' constituting the second layer. Therefore, six laser beams are required to bond the particle 1" to six particles 1, 1, 1, 1, 1', 1', respectively.

In case of a face-centered cubic lattice structure (FCC) in Fig.3c, the particles 1 are arranged in two-dimensional close-packed structure. The second layer is formed to slip by "d" in the X direction and also by (1/√3) d in the Y direction relative to the first layer. The third layer is formed to slip relative to the second layer in the same manner as the second layer. The fourth and later (4+3n) layers are formed in the same patterns as the first layer, the fifth and later (5+3n) layers are formed in the same patterns as the second layer, the sixth and later (6+3n) layers are formed in the same patterns as the third layer, wherein "n" is a natural number, so that a three-dimensional face-centered cubic lattice structure (FCC) is constructed. A particle 1" which has just been positioned is in contact with six previously positioned particles, three of which are the particles 1 constituting the first layer and the others are the three particles l'constituting the second layer. Therefore, six laser beams are required to bond the particle 1" to six particles 1, 1, 1, 1', 1', 1', respectively.

In case of a hexagonal close-packed lattice structure (HCP) in Fig.3c, the particles 1 are arranged in two-dimensional close-packed structure. The second layer is formed to slip by d in X direction and also by (1/√3) d in Y direction relative to the first layer. The third and later odd layers are formed in the same patterns as the first layer, and the forth and later even layers are formed as like as the second layer, so that a three-dimensional hexagonal close-packed lattice structure (HCP) is constructed. Since the particles have at most six contact areas when they are placed in this structure, six beams are required.

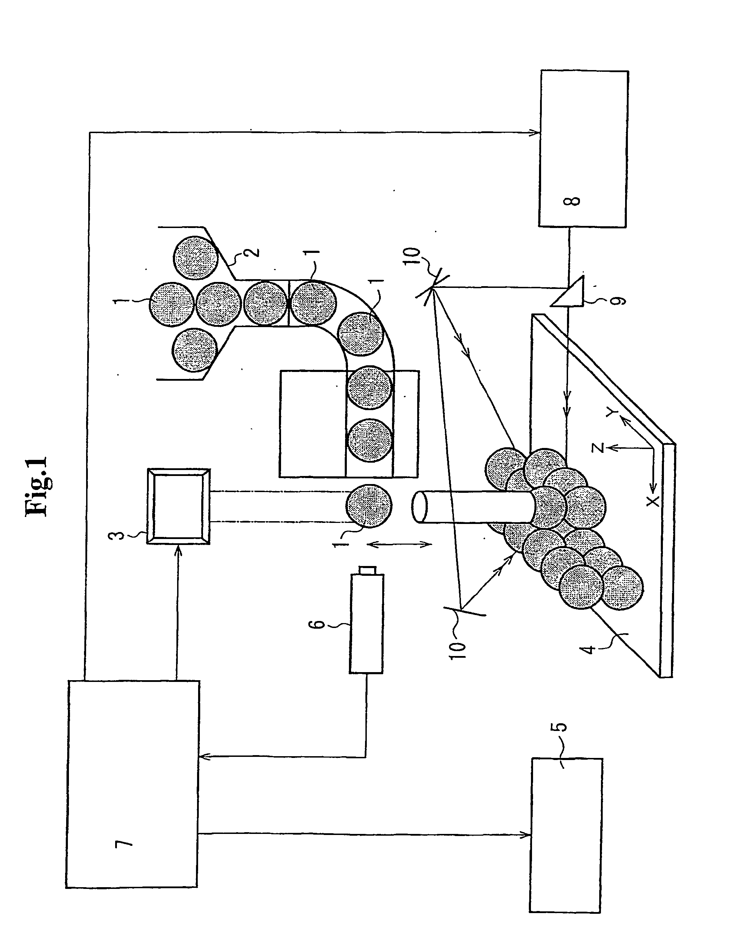

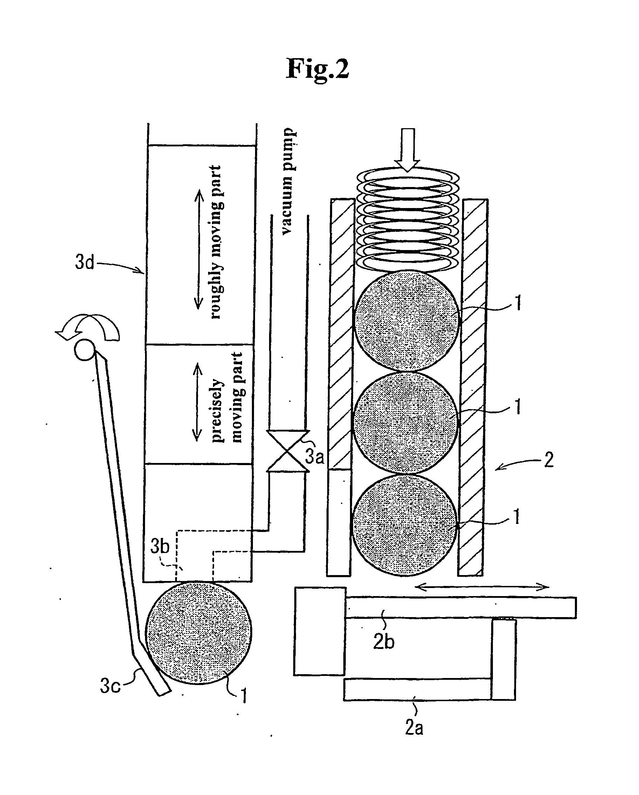

As shown in Fig.1, the spherical fine particle 1 is fed from a cartridge 2 one by one, sequentially, and held by a holder of a precisional manipulator 3. The holder preferably has microvalve 3a which transmits negative pressure from a vacuum pump to a vacuum port 3b on the tip of the manipulator and shuts off the transmission of the negative pressure, alternately, as shown in Fig.2. The reference numeral 3c in Fig.2 represents a particle holder. The cartridge 2 may function such that a piezoactuator 2a moves a feeding microtable 2b forward and backward so as to feed the particles one by one.

A mover for moving the holder preferably has a piezoactuator 3d which roughly and also precisely moves the holder only upward and downward (in Z direction), as shown in Figs.1 and 2. The particle is moved in horizontal direction (X-Y direction) by a driving device 5 via a base plate 4. The driver 5 also moves the base plate 4 in Z direction. The base plate 4 steps down by a thickness of one layer to form the second and later layers of the three dimensional body.

In this embodiment, each spherical fine particle fed from the cartridge 2 is measured its diameter by a particle diameter measuring device 6 and the measurement is inputted to a control computer 7. The computer 7 controls the precisional manipulator 3, driver 5 and laser oscillation system 8. Laser beams generated by the laser oscillation system 8 are irradiated to contact areas of the particles via a beam splitter 9 and mirrors 10.

The process for forming the three-dimensional structure by the device shown in Fig.1 consists of steps of:
i) feeding one particle 1 from the cartridge 2;
ii) holding the fed particle 1 by the precisional manipulator 3;
iii) measuring the diameter of the particle1 by the measuring devise 6 to detect the central position thereof;
iv) moving the particle 1 by using the X-Y-Z stage and the roughly moving part of the manipulator 3 such that the central portion of the particle 1 nearly corresponds to the target position and the particle 1 becomes in contact with the neighboring ones. The whole manipulator 3 moves only upward and downward. It should be noted that the direction of the up and down movement thereof is shifted by a certain angle away from Z axis;
v) irradiating laser beams to the contact areas of the particle to neighboring particles to fuse the contact areas;
vi) moving the particle slightly and precisely by using the precisely moving part of the manipulator 3 so that the center of the particle is positioned at the target position before the fused areas become hard;
vii) releasing the particle 1 from the manipulator 3 after the fused areas become hard; and
viii) repeating the above steps i) to vii) as many turns as required.

In the above step iii), the precise measurement of the diameter of each particle is conducted for the purpose of detection of the center position thereof. The particles 1 inevitably have a statistical size distribution, the maximum of which about three times as large as the standard deviation. Thus, the center of each particle slips away from the target position by an amount at most about three times as large as the standard deviation when the particle is brought into contact with the neighboring particles. The deviation can be detected quantitatively by measuring the diameter of the particle to be bonded precisely.

In the above steps v) and vi), the laser beams are irradiated to the plural contact areas of the neighboring particles to fuse these areas, simultaneously, and the precisely moving part of the manipulator 3 is driven immediately to move the particle to adjust its position, so that each particle is positioned at the target position accurately. The particle needs to be moved over before the fused areas become hard, which is finished preferably within several microseconds. The precisely moving part is preferably moved corresponding to the vector directing from the center of the particle concerned to the target coordinate position thereof.

As described above, the method and device according to the present invention provides a body having a three-dimensional structure in which each spherical fine particle is positioned at the determined position with high accuracy.

## Claims

1. A method for forming a body having a three-dimensional structure, in which spherical fine particles are arranged in three dimensions and the neighboring particles are bonded to each other, by repeatedly conducting a process consisting of steps of;
bringing a particle into contact with other particles neighboring thereto and then forming fused areas at the contact areas of the particles;
adjusting the position of the particle before the fused areas become hard; and
hardening the fused areas to bond the particles.

2. A method for forming a body having a three-dimensional structure as claimed in claim 1, wherein the particles are bonded by being heated and fused locally at the areas where they are in contact with each other.

3. A method for forming a body having a three-dimensional structure as claimed in claim 2, wherein energy beams are irradiated to fuse the contact areas locally.

4. A method for forming a body having a three-dimensional structure as claimed in claim 3, wherein the energy beams are laser beams.

5. A method for forming a body having a three-dimensional structure as claimed in any one of claims 2 through 4, wherein a plurality of said contact areas are fused simultaneously.

6. A method for forming a body having a three-dimensional structure as claimed in any one of claims 1 through 5, wherein the diameter of the particle to be bonded is measured before the particle is brought into contact with said other particles, so that the particle is moved on the basis of the measurement.

7. A method for forming a body having a three-dimensional structure as claimed in any one of claims 1 through 6, wherein the average distance between the centers of the particles constituting the three-dimensional body is expressed by "d", the average diameter of the particle before bonded is expressed by "d + Δd", and the standard deviation of the size distribution of the particles before bonded is expressed by " σ ", wherein Δd is 2.5 to 4 times as large as σ.

8. A method for forming a body having a three-dimensional structure as claimed in any one of claims 1 through 7, wherein the particles have a diameter of 1000 µm or smaller.

9. A device for forming a body having a three-dimensional structure, in which spherical fine particles are arranged in three-dimensions and the neighboring particles are bonded to each other, comprising:
a holder for holding a particle on its tip;
a mover for moving the holder;
at least one energy beam irradiator to irradiate at least one energy beam to the outer surface of the particle held by the holder; and
a controller for controlling a process consisting of steps of moving the holder holding a particle by the mover to bring the particle in contact with other particles; fusing the contact areas of the particles; adjusting the location of the particle held by the holder before the fused contact areas become hard; and hardening the fused areas to bond the particles to each other.

10. A device for forming a body having a three-dimensional structure as claimed in claim 9, the energy beam is a laser beam.

11. A device for forming a body having a three-dimensional structure as claimed in claim 9 or 10, wherein a plurality of laser beams are irradiated so that a plurality of said contact areas are fused simultaneously.

## Patentansprüche

1. Verfahren zum Bilden eines Körpers, der eine dreidimensionale Struktur hat, in der sphärische feine Partikel in drei Dimensionen angeordnet sind und die benachbarten Partikel aneinander gebunden sind, durch wiederholtes Durchführen eines Verfahrens, bestehend aus den Schritten des:
Inkontaktbringens eines Partikels mit anderen Partikeln, die dazu benachbart sind und dann Bilden geschmolzener Flächen an den Kontaktflächen der Partikel;
Ausrichten der Position der Partikel, bevor die geschmolzenen Flächen hart werden;
und Härten der geschmolzenen Flächen, um die Partikel zu binden.

2. Verfahren zum Bilden eines Körpers, der eine dreidimensionale Struktur, wie in Anspruch 1 beansprucht, hat, wobei die Partikel gebunden werden, indem sie erhitzt und lokal an den Flächen geschmolzen werden, an denen sie miteinander in Kontakt sind.

3. Verfahren zum Bilden eines Körpers, der eine dreidimensionale Struktur, wie in Anspruch 2 beansprucht, hat, wobei Energiestrahlen ausgestrahlt werden, um die Kontaktflächen lokal zu schmelzen.

4. Verfahren zum Bilden eines Körpers, der eine dreidimensionale Struktur, wie in Anspruch 3 beansprucht, hat, wobei die Energiestrahlen Laserstrahlen sind.

5. Verfahren zum Bilden eines Körpers, der eine dreidimensionale Struktur, wie in irgendeinem der Ansprüche 2 bis 4 beansprucht, hat, wobei eine Vielzahl dieser Kontaktflächen simultan geschmolzen werden.

6. Verfahren zum Bilden eines Körpers, der eine dreidimensionale Struktur, wie in irgendeinem der Ansprüche 1 bis 5 beansprucht, hat, wobei der Durchmesser des zu bindenden Partikels gemessen wird, bevor das Partikel mit diesen anderen Partikeln in Kontakt gebracht wird, so dass das Partikel auf der Basis der Messung bewegt wird.

7. Verfahren zum Bilden eines Körpers, der eine dreidimensionale Struktur, wie in irgendeinem der Ansprüche 1 bis 6 beansprucht, hat, wobei der mittlere Abstand zwischen den Mittelpunkten der Partikel, aus denen der dreidimensionale Körper besteht, durch "d" ausgedrückt wird, der mittlere Durchmesser des Partikels, bevor es gebunden wird, als "d + Δd" ausgedrückt wird und die Standardabweichung der Größenverteilung der Partikel, bevor sie gebunden werden, als "σ" ausgedrückt wird, wobei Δd 2,5 bis 4 Mal so groß ist wie σ.

8. Verfahren zum Bilden eines Körpers, der eine dreidimensionale Struktur, wie in irgendeinem der Ansprüche 1 bis 7 beansprucht, hat, wobei die Partikel einen Durchmesser von 1000 µm oder kleiner haben.

9. Vorrichtung zum Bilden eines Körpers, der eine dreidimensionale Struktur hat, in der sphärische, feine Partikel in drei Dimensionen angeordnet sind und die benachbarten Partikel aneinander gebunden sind, umfassend:
einen Halter zum Halten eines Partikels an seiner Spitze;
eine Bewegungsvorrichtung, um den Halter zu bewegen;
mindestens einen Energiestrahlstrahler, um mindestens einen Energiestrahl auf die äußere Oberfläche des Partikels, gehalten von dem Halter, zu strahlen;
und ein Steuergerät, um ein Verfahren zu steuern, bestehend aus den Schritten des Bewegens des Halters, der ein Partikel hält, mittels der Bewegungsvorrichtung, um das Partikel mit anderen Partikeln in Kontakt zu bringen; des Schmelzens der Kontaktflächen der Partikel; des Ausrichtens des Orts bzw. der Lage des Partikels, das durch den Halter gehalten wird, bevor die geschmolzenen Kontaktflächen hart werden; und des Härtens der geschmolzenen Flächen, um die Partikel aneinander zu binden.

10. Vorrichtung zum Bilden eines Körpers, der eine dreidimensionale Struktur, wie in Anspruch 9 beansprucht, hat, wobei der Energiestrahl ein Laserstrahl ist.

11. Vorrichtung zum Bilden eines Körpers, der eine dreidimensionale Struktur, wie in Anspruch 9 oder 10 beansprucht, hat, wobei eine Vielzahl von Laserstrahlen ausgestrahlt werden, so dass eine Vielzahl dieser Kontaktflächen simultan geschmolzen wird.

## Revendications

1. Procédé de formation d'un corps de structure tridimensionnelle, dans lequel de fines particules sphériques sont agencées en trois dimensions et les particules avoisinantes sont collées les unes aux autres, par l'exécution répétée d'un procédé consistant en les étapes de :
mise d'une particule en contact avec d'autres particules avoisinant celle-ci et ensuite formation de zones fusionnées au niveau des zones de contact des particules ;
ajustement de la position de la particule avant que les zones fusionnées ne durcissent ; et
durcissement des zones fusionnées pour coller les particules.

2. Procédé de formation d'un corps de structure tridimensionnelle selon la revendication 1, dans lequel les particules sont collées en étant chauffées et localement fusionnées au niveau des zones où elles sont en contact mutuel.

3. Procédé de formation d'un corps de structure tridimensionnelle selon la revendication 2, dans lequel des faisceaux d'énergie sont irradiés pour fusionner les zones de contact localement.

4. Procédé de formation d'un corps de structure tridimensionnelle selon la revendication 3, dans lequel les faiscaux d'énergie sont des faisceaux laser.

5. Procédé de formation d'un corps de structure tridimensionnelle selon l'une quelconque des revendications 2 à 4, dans lequel une pluralité desdites zones de contact sont simultanément fusionnées.

6. Procédé de formation d'un corps de structure tridimensionnelle selon l'une quelconque des revendications 1 à 5, dans lequel le diamètre de la particule à fusionner est mesuré avant la mise en contact de la particule avec lesdites autres particules, de sorte que la particule soit déplacée sur la base de la mesure.

7. Procédé de formation d'un corps de structure tridimensionnelle selon l'une quelconque des revendications 1 à 6, dans lequel la distance moyenne séparant les centres des particules constituant le corps tridimensionnel est exprimé par «d», le diamètre moyen de la particule avant qu'elle ne soit collée est exprimé par «d + Δd», et l'écart-type de la distribution des tailles des particules avant qu'elles ne soient collées est exprimé par «σ», où Δd est de 2,5 à 4 fois plus grand que σ.

8. Procédé de formation d'un corps de structure tridimensionnelle selon l'une quelconque des revendications 1 à 7, dans lequel les particules ont un diamètre inférieur ou égal à 1000 µm.

9. Dispositif de formation d'un corps de structure tridimensionnelle, dans lequel de fines particules sphériques sont agencées en trois dimensions et les particules avoisinantes sont collées les unes aux autres, comprenant :
un dispositif de maintien pour maintenir une particule sur sa pointe ;
un dispositif de déplacement pour déplacer le dispositif de maintien ;
au moins un irradiateur de faisceau d'énergie pour irradier au moins un faisceau d'énergie vers la surface externe de la particule maintenue par le dispositif de maintien ; et
un contrôleur pour commander un procédé consistant en des étapes de déplacement du dispositif de maintien maintenant une particule, au moyen du dispositif de déplacement, pour mettre la particule en contact avec d'autres particules ; fusionnement des zones de contact des particules ; ajustement de l'emplacement de la particule maintenue par le dispositif de maintien avant que les zones de contact fusionnées ne durcissent ; et durcissement des zones fusionnées pour coller les particules les unes aux autres.

10. Dispositif de formation d'un corps de structure tridimensionnelle selon la revendication 9, dans lequel le faisceau d'énergie est un faisceau laser.

11. Dispositif de formation d'un corps de structure tridimensionnelle selon la revendication 9 ou 10, dans lequel une pluralité de faisceaux laser sont irradiés de manière à ce qu'une pluralité desdites zones de contact soient simultanément fusionnées.
